(19) **Europäisches Patentamt / European Patent Office / Office européen des brevets**

(11) **EP 4 425 580 A1**

(12) **EUROPEAN PATENT APPLICATION**
published in accordance with Art. 153(4) EPC

(43) Date of publication:
04.09.2024 Bulletin 2024/36

(21) Application number: 22887272.7

(22) Date of filing: 21.06.2022

(51) International Patent Classification (IPC):
$H01L\ 31/055^{(2014.01)}$    $H01L\ 31/052^{(2014.01)}$
$H01L\ 31/048^{(2014.01)}$

(52) Cooperative Patent Classification (CPC):
H01L 31/048; H01L 31/052; H01L 31/055

(86) International application number:
PCT/KR2022/008736

(87) International publication number:
WO 2023/075066 (04.05.2023 Gazette 2023/18)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 29.10.2021 KR 20210146625

(71) Applicant: Korea University Research and Business Foundation
Seoul 02841 (KR)

(72) Inventors:
• KANG, Yong Tae
Seoul 06346 (KR)
• SONG, Min-Soo
Seoul 05224 (KR)
• LEE, Jae Won
Seoul 02583 (KR)
• JUNG, Han-Sol
Hanam-si, Gyeonggi-do 13011 (KR)

(74) Representative: Schmitt-Nilson Schraud Waibel Wohlfrom
Patentanwälte Partnerschaft mbB
Pelkovenstraße 143
80992 München (DE)

(54) **EMULSION SPECTRAL FLUID FILTER CAPABLE OF CONTROLLING LIGHT WAVELENGTH ABSORPTION, AND MANUFACTURING METHOD THEREFOR**

(57) An emulsion spectrum fluid filter capable of controlling light wavelength absorption includes a transparent channel formed as a tube of a 90 degrees-rotated U shape, and an emulsion received in the transparent channel, wherein the emulsion may include dispersed oil and surfactant. Further, a method for preparing the emulsion is disclosed.

EP 4 425 580 A1

# FIG. 1

## Description

[TECHNICAL FIELD]

The present disclosure relates to an emulsion spectrum fluid filter capable of controlling light wavelength absorption and a method for preparing an emulsion thereof.

The present disclosure is derived from research conducted as a part of collective research support (R&D) as supported by the Ministry of Science and ICT (Project identification number: 1711119436, Research management agency: National Research Foundation of Korea, Research project name: Plus Energy Building Innovation Technology Research Center, Host organization: Korea university's industry-academic cooperation group, Research period: 2020.07.01 to 2021.05.31, Contribution ratio: 1/1).

Further, there is no property interest of the Korean government in any aspect of the present disclosure.

[BACKGROUND ART]

Solar power generation produces electricity through semiconductors when a light source is supplied thereto using a photoelectric effect. A solar panel is made up of solar cells which are classified into a silicon semiconductor cell and a compound semiconductor cell depending on a material thereof.

Most products currently in the solar energy market are based on solar cells made of silicon. Among them, a single crystal silicon solar cell is mainly used. However, the solar cell does not utilize an entire wavelength of sunlight. The single crystal silicon solar cell produces electricity using a wavelength of 730nm to 1130nm though there is a variation of the used wavelength depending on a material. In this regard, the remaining wavelength except for 730nm to 1130nm is not involved in electricity production and plays a role in raising a temperature of an entirety of the solar panel composed of the solar cells. In this regard, the photovoltaic efficiency of the solar panel decreases as the temperature thereof rises. For example, when the temperature of the solar panel increases by 1 degree C, the photovoltaic efficiency thereof may decrease by about 0.5%.

[DETAILED DESCRIPTION OF THE INVENTION]

[TECHINICAL PROBLEM]

A purpose of the present disclosure is to provide an emulsion spectrum fluid filter capable of controlling light wavelength absorption in which an emulsion is composed of oil and surfactant and is chemically stable, and has low risk of precipitation and resulting corrosion; the emulsion is a mixture of oil which effectively absorbs light of a short wavelength range and water which effectively absorbs light of a long wavelength range, and thus has excellent absorption of light of a wavelength except for a wavelengths effective for the photoelectric effect; the oil is dispersed in a form of fine particles in the emulsion and was added thereto at a low concentration, and thus there is no significant difference between thermal conductivity of the oil and that of water; and the filter may be applied in a form of a flow channel in a technical field including solar power generation, and requiring an light wavelength filter such that the emulsion may be freely injected or discharged to or from the channel when necessary. Further, a purpose of the present disclosure is to provide a method for prepping the emulsion thereof.

The technical purposes sought to be achieved in the present disclosure are not limited to the technical purposes mentioned above. Other technical purposes not mentioned may be clearly understood by those skilled in the art in the technical field to which the present disclosure belongs from the description below.

[TECHNICAL SOLUTION]

An emulsion spectrum fluid filter capable of controlling light wavelength absorption in accordance with an embodiment of the present disclosure may include a transparent channel formed as a tube of a 90 degrees-rotated U shape, and an emulsion received in the transparent channel, wherein the emulsion may include dispersed oil and surfactant.

Further, the transparent channel may include an inner wall having a 90 degrees-rotated U shaped cross section, and an outer wall located out of the inner wall and having a 90 degrees-rotated U shaped cross section, wherein the transparent channel may have an inlet and an outlet defined at one end thereto, and a curved portion formed at the other end thereof opposite to the one end.

Further, the transparent channel may include a first area where the emulsion flows from the inlet to the curved portion, and a second area located on top of the first area, wherein the emulsion flows from the curved portion to the outlet in the second area.

Further, a solar cell may be fixed to an upper surface of the inner wall in the first area.

Further, in the first area, the emulsion may absorb heat from the solar cell, wherein in the second area, the emulsion may absorb light having a wavelength out of a range of 730nm to 1130nm from light incident on the solar cell.

Further, the oil may include at least one of silicone oil, corn oil, mineral oil (white oil), lubricant, or soybean oil.

Further, a content of the oil may be in a range of 0.05 wt% or smaller based on a total weigh of the emulsion.

Further, the surfactant may include a mixture of a low HLB surfactant and a high HLB surfactant, wherein the surfactant may include at least two selected from oleic acid, sorbitan trioleate, sorbitan monooleate, sorbitan monostearate, sorbitan monolaurate, polyoxyethylene(5) sorbitan monooleate, triethanolamine oleate, polyoxyethylene(20) sorbitan monostearate, polyoxyethylene(20) sorbitan monooleate, polyoxyethylene(20) sorbitan monolaurate, sodium oleate, and potassium oleate.

Further, a mixing ratio of the oil and the surfactant may range from 2:1 to 8:1.

A method for preparing an emulsion capable of controlling light wavelength absorption in accordance with an embodiment of the present disclosure may include mixing a low HLB surfactant and a high HLB surfactant with each other to produce a surfactant mixture fluid, mixing oil with the surfactant mixture fluid to produce a mixed fluid, and mixing water with the mixed fluid.

Further, the method may further include, after the mixing of the water with the mixed fluid, performing ultrasonic pulverization of a mixture of the water and the mixed fluid.

Further, the oil may include at least one of silicone oil, corn oil, mineral oil (white oil), lubricant, or soybean oil.

Further, in the mixing of the oil with the surfactant mixture fluid to produce the mixed fluid, a content of the oil may be in a range of 0.05 wt% or smaller based on a total weigh of the emulsion.

Further, in the mixing of the low HLB surfactant and the high HLB surfactant with each other to produce the surfactant mixture fluid, the surfactant mixture fluid may include at least two selected from oleic acid, sorbitan trioleate, sorbitan monooleate, sorbitan monostearate, sorbitan monolaurate, polyoxyethylene(5) sorbitan monooleate, triethanolamine oleate, polyoxyethylene(20) sorbitan monostearate, polyoxyethylene(20) sorbitan monooleate, polyoxyethylene(20) sorbitan monolaurate, sodium oleate, and potassium oleate.

Further, in the mixing of the oil with the surfactant mixture fluid to produce the mixed fluid, a mixing ratio of the oil and the surfactant may range from 2:1 to 8:1.

[ADVANTAGEOUS EFFECTS OF THE INVENTION]

According to an embodiment of the present disclosure, the emulsion is composed of oil and surfactant and is chemically stable, and has low risk of precipitation and resulting corrosion; the emulsion is a mixture of oil which effectively absorbs light of a short wavelength range and water which effectively absorbs light of a long wavelength range, and thus has excellent absorption of light of a wavelength except for a wavelengths effective for the photoelectric effect.

Further, according to an embodiment of the present disclosure, the oil is dispersed in a form of fine particles in the emulsion and was added thereto at a low concentration, and thus there is no significant difference between thermal conductivity of the oil and that of water; and the filter may be applied in a form of a flow channel in a technical field including solar power generation, and requiring an light wavelength filter such that the emulsion may be freely injected or discharged to or from the channel when necessary.

The effects that may be obtained from the present disclosure are not limited to the effects as mentioned above. Other effects not mentioned may be clearly understood by those skilled in the art in the technical field to which the present disclosure belongs from the description below.

[DESCRIPTION OF THE DRAWINGS]

FIG. 1 is a cross-sectional view schematically showing a state in which an emulsion spectrum fluid filter capable of controlling light wavelength absorption according to an embodiment of the present disclosure is applied,

FIG. 2 is a graph showing a power density based a wavelength of sunlight.

FIG. 3 is a flowchart for illustrating a method for manufacturing an emulsion according to an embodiment of the present disclosure.

FIG. 4 and FIG. 6 are graphs showing characteristics of the emulsion according to one embodiment of the present disclosure,

FIG. 7 and FIG. 8 are graphs showing characteristics of an emulsion according to Comparative Example.

FIG. 9 to FIG. 10 are graphs comparing characteristics of a fluid filter according to one embodiment of the present disclosure and an emulsion according to Comparative Example with each other.

[BEST MODE]

Hereinafter, embodiments of the present disclosure will be described in more detail with reference to the attached drawings. Embodiments of the present disclosure may be modified in various forms, and the scope of the present disclosure should not be construed as being limited to the embodiments below. The embodiments are provided to more fully describe the present disclosure to those with average knowledge in the art. Therefore, the shapes of elements in the drawing are exaggerated to emphasize a clearer illustration.

The composition of the invention to clarify the solution to the problem that the present disclosure seeks to solve is described in detail with reference to the attached drawings based on preferred embodiments of the present disclosure. In assigning reference numbers to components of a drawing, the same reference number is assigned to the same component across different drawings. When describing the drawing, a component of another drawing may be cited when necessary.

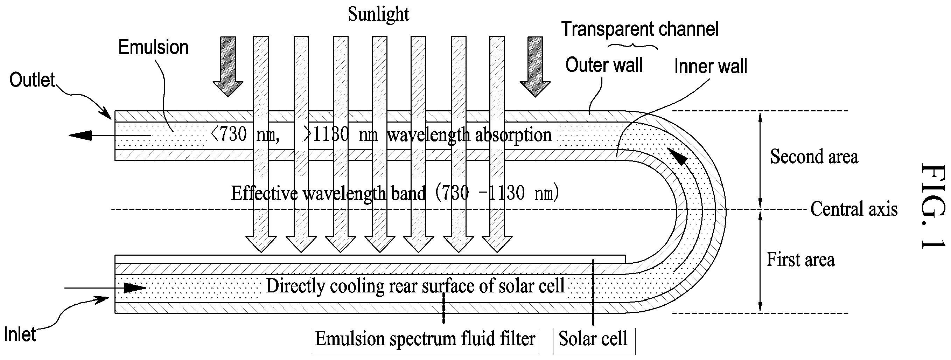

FIG. 1 is a cross-sectional view schematically showing a state in which an emulsion spectrum fluid filter capable of controlling light wavelength absorption according to an embodiment of the present disclosure is applied.

Referring to FIG. 1, an emulsion spectrum fluid filter capable of controlling light wavelength absorption according to an embodiment of the present disclosure may be constructed in a structure in which an emulsion is injected into a transparent channel formed in a tube shape with a cross-section of '90 degrees-rotated U shape'.

The transparent channel may be composed of an inner wall with a '90 degrees-rotated U shaped' cross-section, an outer wall located out of the inner wall and with a '90 degrees-rotated U shaped' cross-section, and a connecting side wall (not shown) connecting the inner wall and the outer wall to each other. In this regard, it is desirable that the transparent channel be made of a material with excellent transmittance and thermal conductivity, and the present disclosure does not limit this material.

The transparent channel has an inlet and an outlet defined at one side thereof, and has a curved portion at the other side thereof opposite to one side, so that the cross section thereof may be formed in a '90 degrees-rotated U shape'. In this regard, a pump (not shown) may be connected to at least one of the inlet and the outlet and may be configured to pump the emulsion to generate a forced flow thereof.

In other words, the emulsion introduced into the transparent channel through the inlet may flow through the curved portion and be discharged through the outlet while a flow direction thereof is reversed.

Specifically, the transparent channel includes a first area where the emulsion is transferred in one direction from the inlet to the curved portion, and a second area located on top of the first area where the emulsion is transferred in an opposite direction from the curved portion to the outlet.

In this regard, a vertical direction may be defined as a direction in which light flows.

In one example, although not shown, the transparent channel may be formed in a closed structure, a cooling unit (not shown) and the pump (not shown) may be formed at one side thereof, so that cooled emulsion may be forcibly transferred to the curved portion, and then the emulsion that has flowed through the curved portion may be circulated within the transparent channel.

In the first area, a solar cell may be disposed on an outer surface of the inner wall (an upper surface thereof in FIG. 1).

In one example, fixing means (not shown) may be disposed on the upper surface of the inner wall to fix the solar cell to the inner wall.

In this regard, the outer surface of the inner wall may be defined as a surface facing a central axis of the transparent channel.

The emulsion injected through the inlet may have a lower temperature than that of the solar cell, and the emulsion may cool the solar cell via heat conduction in the first area.

The emulsion that has absorbed the heat of the solar cell in the first area may flow into the second area through the curved portion. Then, in the second area, the emulsion may absorb light of a wavelength band (smaller than 730nm, or greater than 1130nm) excluding an effective wavelength (730nm to 1130nm) of sunlight.

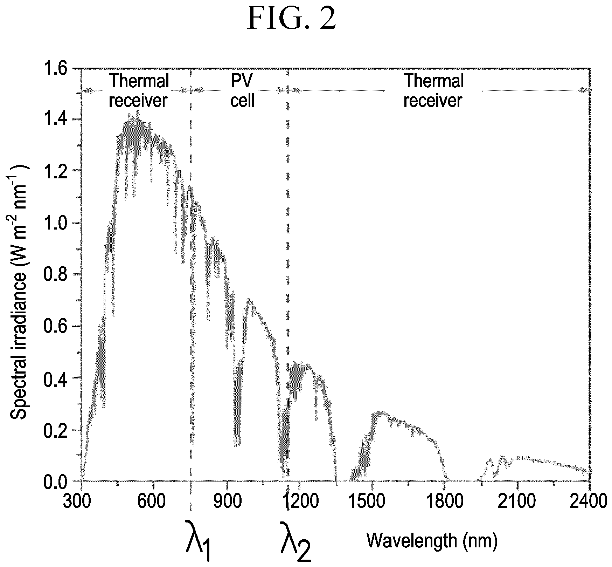

FIG. 2 is a graph showing a power density based on a wavelength of sunlight.

In this regard, referring to FIG. 2, the effective wavelength may be defined as a wavelength effective in terms of the photoelectric effect. In one example, in accordance with the present disclosure, when the solar cell is embodied as a single crystal silicon solar cell, the effective wavelength may be defined as a wavelength of 730nm to 1130nm as a wavelength band in which the solar cell produces electricity. The wavelength other than the effective wavelength of 730nm to 1130nm may not be involved in electricity generation but may increase the temperature of the entire solar panel composed of solar cells.

In other words, the emulsion present in the second area may absorb light in the wavelength band (smaller than 730nm, or greater than 1130nm) that leads to the temperature rise of the solar cell, thereby suppressing the temperature rise while maintaining the photoelectric efficiency of the solar cell.

The emulsion may be composed of a water-based mixture including oil and surfactant.

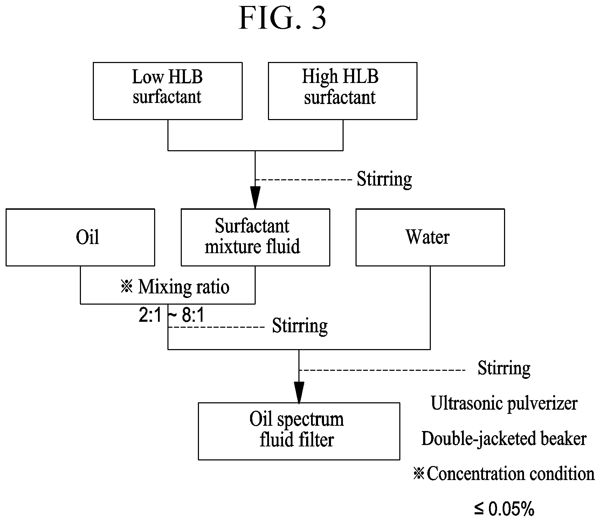

FIG. 3 is a flowchart for illustrating a method for manufacturing an emulsion according to an embodiment of the present disclosure.

Referring to FIG. 3, the method for manufacturing the emulsion according to one embodiment of the present disclosure first mixes a low HLB surfactant and a high HLB surfactant with each other based on a HLB value of the oil.

In this regard, since the HLB value of general oil is between 6 and 12, the HLB value of the low HLB surfactant is defined as between 0 and 6, and the HLB value of high HLB surfactant is defined as between 12 and 18.

In a descending order of the HLB value, the surfactant may include oleic acid, sorbitan trioleate, sorbitan monooleate, sorbitan monostearate, sorbitan monolaurate, polyoxyethylene(5) sorbitan monooleate, triethanolamine oleate, polyoxyethylene(20) sorbitan monostearate, polyoxyethylene(20) sorbitan monooleate, polyoxyethylene(20) sorbitan monolaurate, sodium oleate, and potassium oleate. The present disclosure is not limited thereto.

Before mixing the surfactant with the oil, the surfactants should be mixed with each other to produce a surfactant mixture fluid with an appropriate HLB value. Then, the surfactant mixture fluid may be mixed with the oil.

In this regard, each oil has a unique HLB value. For example, when the HLB value of silicone oil is 11, two types of surfactants may be mixed with each other to produce a surfactant mixture with HLB 11. When the two surfactants are mixed with each other to produce the surfactant mixture with the HLB value equal to that of the oil, the HLB value of the surfactant mixture is referred to as the appropriate HLB value.

The emulsion containing a single surfactant has poor stability. For this reason, use of the surfactant mixture may improve the stability of the emulsion. The emulsion is a mixture of water and oil. Thus, high stability thereof is required. For this reason, use of the surfactant mixture may improve the stability of the emulsion.

Oil may include at least one of viscous fluids such as silicone oil, corn oil, mineral oil (white oil), lubricant, and soybean oil.

In this regard, it is desirable that the oil be an ingredient that maintains a liquid state at room temperature. That is, it is preferable that the oil is a vegetable oil. Animal oil exists in a solid state at room temperature. Thus, it is difficult to use the animal oil because it is not present in a liquid state. Additionally, among vegetable oils, a coconut oil may not be used because it is solid at room temperature.

In this regard, an amount of the oil may be up to 2 to 8 times by mass of the surfactant mixture fluid. That is, a mixing ratio of the oil and surfactant mixture fluid may be set to be in a range of 2:1 to 8:1.

In this regard, if the mixing ratio of the oil and the surfactant mixture fluid is smaller than 2:1, an unused amount of the surfactant may increase during the mixing process, which may cause aggregation between the surfactants. If the mixing ratio of the oil and the surfactant mixture fluid is greater than 8:1, aggregation between the remaining oils may occur due to an insufficient amount of the surfactant to disperse the oil during the mixing process.

The surfactant is added to disperse oil in a form of droplets while the oil is not separated from water.

The surfactant may be any one or more selected from the group consisting of anionic surfactants, cationic surfactants, nonionic surfactants, and amphoteric surfactants.

This classification is based on a type of a hydrophilic group. The anionic surfactant refers to a surfactant in which an atomic group (hydrophobic moiety) of a long chain becomes an anion. The anionic surfactant may include soaps, phosphate esters, sulfates, sulfonates, etc. The cationic surfactant refers to a surfactant in which a long chain becomes a cation and may include quaternary ammonium salts, amine salts, and pyridine salts. In addition, the nonionic surfactant refers to a surfactant that does not have a charged group and may include polyethylene glycol, polyhydric alcohol, fatty acid ethylene oxide, etc. The amphoteric surfactant refers to a surfactant that has both a cation and an anion in a molecule and is controlled by pH and includes an amino acid type, a betaine type, etc.

HLB (Hydrophilic Lipophilic Balance) is a numerical representation of a hydrophilicity level and a lipophilicity level of the surfactant. HLB is 1 when the surfactant has the highest lipophilicity. Widely used surfactants usually have an HLB between 1 and 20. Specifically, the HLB value of the surfactant mixture may be obtained based on a following [Equation 1].

[Equation 1]

HLB of oil:

$$HLB_{od} = \frac{(W_A \times HLB_A) + (W_B \times HLB_B)}{(W_A + W_B)}$$

where $W_A$ and $W_B$ are weight fractions of the surfactants mixed with each other, respectively.

For example, when the HLB of silicone oil = 11, HLB of surfactant A ; polyoxyethylene(5) lauryl ether = 10, HLB of surfactant B; polyoxyethylene(10) cetyl ether = 12 may be used. Thus, the two surfactants may be mixed with each other at a ratio of 1:1 to obtain the surfactant mixture having HLB of 11 as the same value as the HLB of silicone oil.

In a later step, a mixture of the oil and the surfactant mixture fluid is mixed with water. At this time, an ultrasonic pulverizer may be used together with stirring to evenly disperse the oil in a form of fine particles. In order to achieve an effective ultrasonic pulverization effect, the temperature of the fluid should be prevented from rising by flowing cooling water with a double-jacketed beaker while using the ultrasonic pulverizer.

During the preparing process, mechanical stirring, ultrasonic pulverization, and magnetic stirring may be used as a method of mixing (stirring) between fluids or between the fluid and particles. In the step of mixing the oil/surfactant with water, the oil may be maintained in the fine particle form via ultrasonic pulverization.

In this regard, when finally adding the oil to the water, an oil concentration should be in a range of a mass fraction of 0.05 or smaller to prevent excessive turbidity caused by the oil remaining in the form of fine particles.

[Example]

This shows an example of emulsion production. Silicone oil (0.05g) was selected as the oil, Span80 (0.00625g) was selected as a low HLB surfactant, and Tween80 (0.00625g) was selected as a high HLB surfactant.

First, Span80 (0.00625g) and Tween80 (0.00625g) were mixed with each other in a stirrer, followed by stirring at 400 rpm for 30 minutes.

Afterwards, silicone oil (0.05 g) was added into the stirrer, followed by stirring at 400 rpm for 30 minutes.

Afterwards, water (99.9375 g) was added into the stirrer, followed by stirring at 400 rpm for 30 minutes, and followed by stirring for 1 hour at 25 degrees Celsius using an ultrasonic grinder (20 Hz).

[Comparative Example]

Water-based nanoemulsion were used as the fluid flowing into the transparent channel.

The nanoemulsion was obtained by dispersing solid nanoparticles in water.

[Characteristics Evaluation]

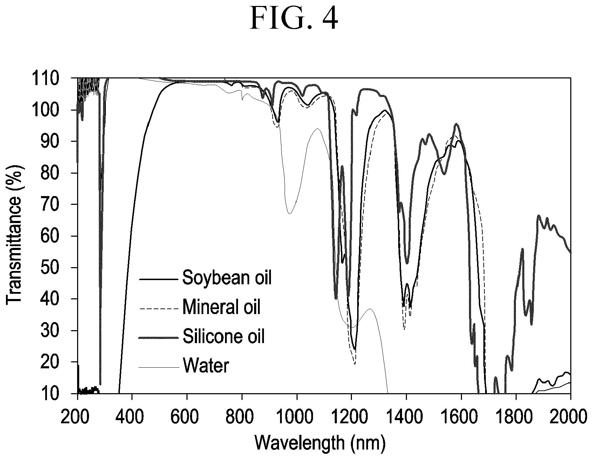

FIG. 4 shows the light transmittance of each of the oils and the water reviewed for the present disclosure. Water exhibited high transmittance in a wavelength band of 730nm or smaller, while the oils all exhibited low transmittance in a wavelength band of 730nm or smaller. In addition, in the wavelength band greater than 1130nm, water as a base of the emulsion spectrum fluid filter had the lowest transmittance and was suitable.

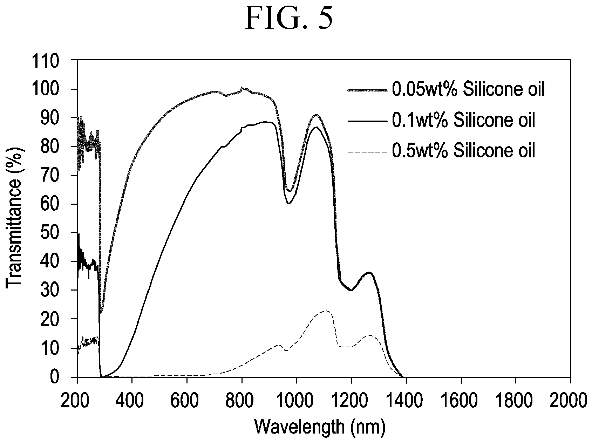

FIG. 5 shows the light transmittance based on a concentration of silicone oil. It may be identified that as the concentration of the oil increases, the light transmittance decreases over all wavelengths. Referring to FIG. 5, it may be identified that 0.05 wt% is a limit concentration of the oil.

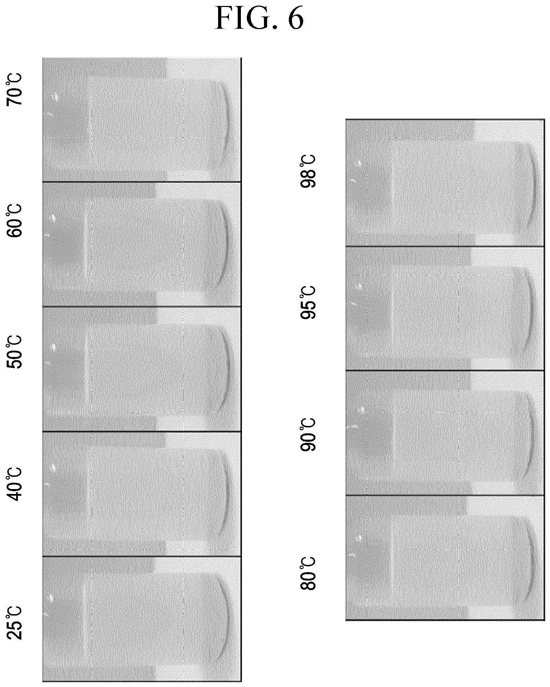

FIG. 6 shows the thermal stability evaluation result of the emulsion spectrum fluid filter with 0.05 wt% of silicone oil added thereto. Interaction between the oil and the surfactant changes as the temperature changes, thereby destroying dispersion of the oil in the emulsion. Since the temperature of the solar cell may rise to 80 to 90°C when being exposed to sunlight without applying cooling technology thereto, temperature stability at this temperature is important.

In accordance with the present disclosure, the concentration of the oil was limited to 0.05 wt%. Thus, oil separation due to dispersion destruction was not identified at the temperature up to 98°C just before the temperature at which water evaporates, thereby exhibiting excellent thermal stability.

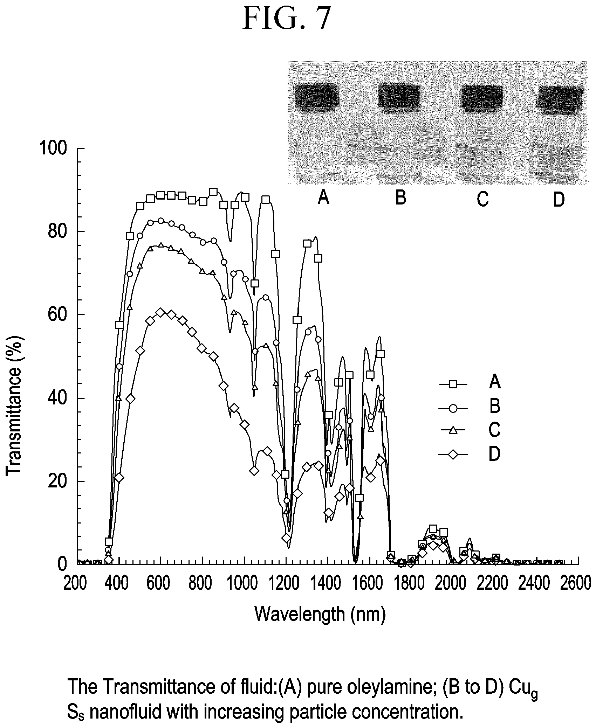

Referring to FIG. 7, the nanofluid of Comparative Example may absorb both ultraviolet and infrared rays. However, there are solid particles in the fluid. The nanofluid of Comparative Example may absorb light of the wavelength needed to generate the electrical energy, and the formation of sediment may occur when the fluid flows.

In FIG. 7, A is oleylamine (C18H37N) fluid, and B to D are oleylamine with $Cu_9S_5$ added thereto at various concentrations, respectively.

In this case, solid nanoparticles may promote conduction heat transfer in a greater manner than water may, and may effectively reduce heat when directly contacting a bottom of the solar panel. However, when the solid nanoparticles flow into an upper portion, the solid nanoparticles may absorb a portion of the wavelength required for the photoelectric effect. Further, the particles may settle down when being used for a long period of time.

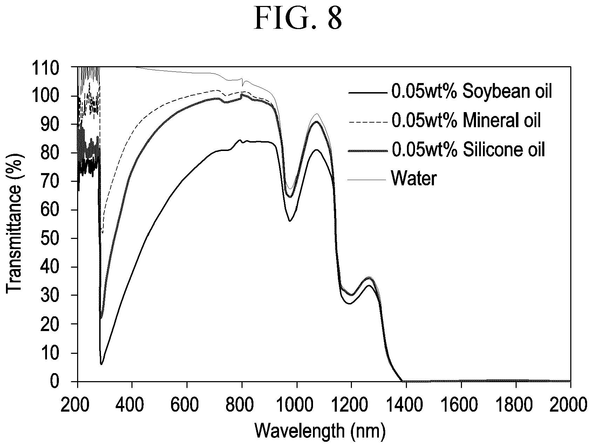

FIG. 8 shows the light transmittance when 0.05 wt% of each of various types of oils was dispersed in water (Present Example) and the light transmittance of water (Comparative Example). Low transmittance in a wavelength of 730nm or smaller was obtained at only the content 0.05 wt% of the oil. Silicone oil was selected as the oil of one embodiment of the present disclosure, and a detailed experiment thereon was conducted.

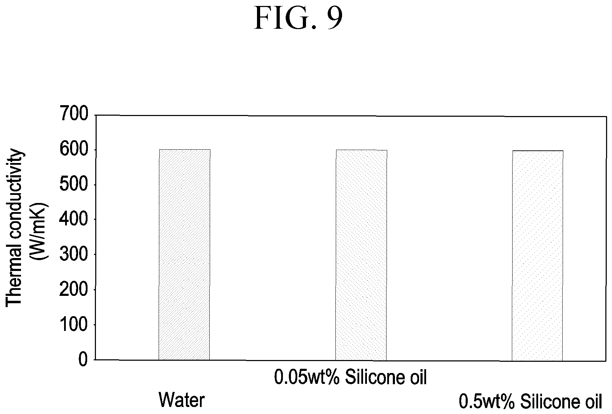

FIG. 9 shows the thermal conductivity based on the concentration of silicone oil. Although the thermal conductivity of silicone oil is lower than that of water, this result is obtained at the low content of the oil. Thus, the thermal conductivity of silicone oil is substantially similar to that of water. In other words, when the silicone oil in is contact with the solar panel and exchanges the heat therewith, it may be expected that the heat exchange of the silicone is similar to that of water.

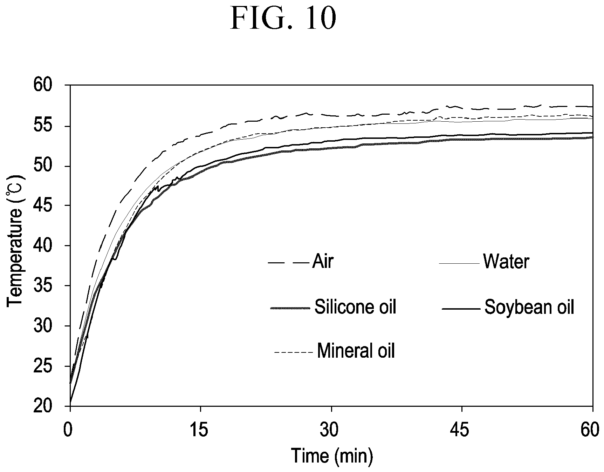

FIG. 10 is a graph of identifying a change in a temperature rise of the solar cell panel based on the type of the oil when the fluid filter is disposed on the solar cell panel.

When nothing is applied onto the panel, that is, only air is present thereon, the temperature reached 57.7°C after 60 minutes. When water was applied onto the panel, the temperature reached 56.2°C. Thus, the water exhibited a cooling effect by 1.5°C. When the oil spectrum fluid filter is applied onto the panel, the cooling effect increases compared to the water. Thus, it may be identified that when the silicone oil is used, the temperature reached 53.6°C. Thus, the oil spectrum fluid filter exhibited a cooling effect by up to 4.1°C.

The above detailed description is illustrative of the present disclosure. Additionally, the foregoing describes preferred embodiments of the present disclosure, and the present disclosure may be used in a variety of different combinations, modifications, and environments. That is, changes or modifications may be made thereto within the scope of the inventive concept disclosed herein, a scope equivalent to the written disclosure, and/or within the scope of technology or knowledge in the art. The written embodiment describes the best state for implementing the technical idea of the present disclosure, and various changes required for specific application fields and uses of the present disclosure may be made. Accordingly, the detailed description of the disclosure above is not intended to limit the present disclosure to the disclosed practice state. Additionally, the appended claims should be construed as including other embodiments.

Claims

1. An emulsion spectrum fluid filter capable of controlling light wavelength absorption, the emulsion spectrum fluid filter comprising:

   a transparent channel formed as a tube of a 90 degrees-rotated U shape; and
   an emulsion received in the transparent channel,
   wherein the emulsion includes dispersed oil and surfactant.

2. The emulsion spectrum fluid filter capable of controlling light wavelength absorption of claim 1, wherein the transparent channel includes:

   an inner wall having a 90 degrees-rotated U shaped cross section; and
   an outer wall located out of the inner wall and having a 90 degrees-rotated U shaped cross section,
   wherein the transparent channel has an inlet and an outlet defined at one end thereto, and a curved portion formed at the other end thereof opposite to the one end.

3. The emulsion spectrum fluid filter capable of controlling light wavelength absorption of claim 2, wherein the transparent channel includes:

   a first area where the emulsion flows from the inlet to the curved portion; and
   a second area located on top of the first area,
   wherein the emulsion flows from the curved portion to the outlet in the second area.

4. The emulsion spectrum fluid filter capable of controlling light wavelength absorption of claim 3, wherein a solar cell is fixed to an upper surface of the inner wall in the first area.

5. The emulsion spectrum fluid filter capable of controlling light wavelength absorption of claim 4, wherein in the first area, the emulsion absorbs heat from the solar cell,
   wherein in the second area, the emulsion absorbs light having a wavelength out of a range of 730nm to 1130nm from light incident on the solar cell.

6. The emulsion spectrum fluid filter capable of controlling light wavelength absorption of claim 1, wherein the oil includes at least one of silicone oil, corn oil, mineral oil (white oil), lubricant, or soybean oil.

7. The emulsion spectrum fluid filter capable of controlling light wavelength absorption of claim 6, wherein a content of the oil is in a range of 0.05 wt% or smaller based on a total weigh of the emulsion.

8. The emulsion spectrum fluid filter capable of controlling light wavelength absorption of claim 1, wherein the surfactant includes a mixture of a low HLB surfactant and a high HLB surfactant,
   wherein the surfactant includes at least two selected from oleic acid, sorbitan trioleate, sorbitan monooleate, sorbitan monostearate, sorbitan monolaurate, polyoxyethylene(5) sorbitan monooleate, triethanolamine oleate, polyoxyethylene(20) sorbitan monostearate, polyoxyethylene(20) sorbitan monooleate, polyoxyethylene(20) sorbitan monolaurate, sodium oleate, and potassium oleate.

9. The emulsion spectrum fluid filter capable of controlling light wavelength absorption of claim 1, wherein a mixing ratio of the oil and the surfactant ranges from 2:1 to 8:1.

10. A method for preparing an emulsion capable of controlling light wavelength absorption, the method comprising:

    mixing a low HLB surfactant and a high HLB surfactant with each other to produce a surfactant mixture fluid;
    mixing oil with the surfactant mixture fluid to produce a mixed fluid; and
    mixing water with the mixed fluid.

11. The method for preparing the emulsion capable of controlling light wavelength absorption of claim 10, wherein the method further comprises, after the mixing of the water with the mixed fluid, performing ultrasonic pulverization of a mixture of the water and the mixed fluid.

12. The method for preparing the emulsion capable of controlling light wavelength absorption of claim 10, wherein the oil includes at least one of silicone oil, corn oil, mineral oil (white oil), lubricant, or soybean oil.

13. The method for preparing the emulsion capable of controlling light wavelength absorption of claim 10, wherein in the mixing of the oil with the surfactant mixture fluid to produce the mixed fluid, a content of the oil is in a range of 0.05 wt% or smaller based on a total weigh of the emulsion.

14. The method for preparing the emulsion capable of controlling light wavelength absorption of claim 10, wherein in the mixing of the low HLB surfactant and the high HLB surfactant with each other to produce the surfactant mixture fluid, the surfactant mixture fluid includes at least two selected from oleic acid, sorbitan trioleate, sorbitan monooleate, sorbitan monostearate, sorbitan monolaurate, polyoxyethylene(5) sorbitan monooleate, triethanolamine oleate, polyoxyethylene(20) sorbitan monostearate, polyoxyethylene(20) sorbitan monooleate, polyoxyethylene(20) sorbitan monolaurate, sodium oleate, and potassium oleate.

15. The method for preparing the emulsion capable of controlling light wavelength absorption of claim 10, wherein in the mixing of the oil with the surfactant mixture fluid to produce the mixed fluid, a mixing ratio of the oil and the surfactant ranges from 2:1 to 8:1.

# FIG. 1

# FIG. 2

# FIG. 3

```
┌──────────────┐        ┌──────────────┐
│   Low HLB    │        │   High HLB   │
│  surfactant  │        │  surfactant  │
└──────┬───────┘        └──────┬───────┘
       │                       │
       └───────────┬───────────┘
                   │
                   ▼ ------------- Stirring

┌──────────┐   ┌──────────────┐   ┌──────────────┐
│   Oil    │   │  Surfactant  │   │    Water     │
│          │   │ mixture fluid│   │              │
└─────┬────┘   └──────┬───────┘   └──────┬───────┘
      │  ※ Mixing ratio │                │
      │    2:1 ~ 8:1     │                │
      └────────┬────────────── Stirring   │
               │                          │
               ▼ ------------------------- Stirring
      ┌──────────────────┐
      │   Oil spectrum   │        Ultrasonic pulverizer
      │   fluid filter   │        Double-jacketed beaker
      └──────────────────┘        ※ Concentration condition
                                          ≤ 0.05%
```

FIG. 4

# FIG. 5

EP 4 425 580 A1

# FIG. 6

# FIG. 7

The Transmittance of fluid:(A) pure oleylamine; (B to D) $Cu_g$ $S_s$ nanofluid with increasing particle concentration.

# FIG. 8

# FIG. 9

# FIG. 10

## INTERNATIONAL SEARCH REPORT

| | International application No. |
|---|---|
| | **PCT/KR2022/008736** |

**A.    CLASSIFICATION OF SUBJECT MATTER**

**H01L 31/055**(2006.01)i; **H01L 31/052**(2006.01)i; **H01L 31/048**(2006.01)i

According to International Patent Classification (IPC) or to both national classification and IPC

**B.    FIELDS SEARCHED**

Minimum documentation searched (classification system followed by classification symbols)

H01L 31/055(2006.01); A23L 33/155(2016.01); F21V 8/00(2006.01); H01L 31/0216(2006.01); H01L 31/0232(2006.01); H01L 31/04(2006.01); H01L 31/042(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 태양 전지(solar cell), 유체 필터(fluid filter), 에멀전(emulsion)

**C.    DOCUMENTS CONSIDERED TO BE RELEVANT**

| Category* | Citation of document, with indication, where appropriate, of the relevant passages | Relevant to claim No. |
|---|---|---|
| A | KR 10-2014-0051947 A (PRAYON) 02 May 2014 (2014-05-02)<br>See claims 1 and 9. | 1-15 |
| A | KR 10-2015-0038381 A (3M INNOVATIVE PROPERTIES COMPANY) 08 April 2015 (2015-04-08)<br>See paragraphs [0014]-[0078]; and figures 1-11 and 14. | 1-15 |
| A | KR 10-2010-0097150 A (SUNPOWER CORPORATION) 02 September 2010 (2010-09-02)<br>See paragraphs [0018]-[0045]; and figures 1-15. | 1-15 |
| A | KR 10-2014-0037372 A (POSCO et al.) 27 March 2014 (2014-03-27)<br>See paragraphs [0045]-[0062]; and figures 1a-6. | 1-15 |
| A | KR 10-2020-0093856 A (KOOKMIN UNIVERSITY INDUSTRY ACADEMY COOPERATION FOUNDATION) 06 August 2020 (2020-08-06)<br>See paragraphs [0022]-[0058]; and figures 1-4. | 1-15 |

☐ Further documents are listed in the continuation of Box C.       ☑ See patent family annex.

| | |
|---|---|
| *    Special categories of cited documents:<br>"A"    document defining the general state of the art which is not considered to be of particular relevance<br>"D"    document cited by the applicant in the international application<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
|---|---|
| **21 September 2022** | **21 September 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

INTERNATIONAL SEARCH REPORT
Information on patent family members

International application No.

**PCT/KR2022/008736**

| Patent document cited in search report | | | Publication date (day/month/year) | Patent family member(s) | | | Publication date (day/month/year) |
|---|---|---|---|---|---|---|---|
| KR | 10-2014-0051947 | A | 02 May 2014 | CN | 103635103 | A | 12 March 2014 |
| | | | | EP | 2731460 | A1 | 21 May 2014 |
| | | | | JP | 2014-520541 | A | 25 August 2014 |
| | | | | US | 2014-0155359 | A1 | 05 June 2014 |
| | | | | WO | 2013-010956 | A1 | 24 January 2013 |
| KR | 10-2015-0038381 | A | 08 April 2015 | CN | 104737039 | A | 24 June 2015 |
| | | | | CN | 104737039 | B | 23 June 2017 |
| | | | | EP | 2880475 | A1 | 10 June 2015 |
| | | | | JP | 2015-533222 | A | 19 November 2015 |
| | | | | JP | 6605328 | B2 | 13 November 2019 |
| | | | | US | 2015-0177432 | A1 | 25 June 2015 |
| | | | | US | 9945994 | B2 | 17 April 2018 |
| | | | | WO | 2014-022049 | A1 | 06 February 2014 |
| KR | 10-2010-0097150 | A | 02 September 2010 | CN | 101897032 | A | 24 November 2010 |
| | | | | CN | 101897032 | B | 10 February 2016 |
| | | | | CN | 105679843 | A | 15 June 2016 |
| | | | | CN | 105679843 | B | 22 May 2018 |
| | | | | EP | 2220688 | A1 | 25 August 2010 |
| | | | | JP | 2011-518422 | A | 23 June 2011 |
| | | | | JP | 2013-138250 | A | 11 July 2013 |
| | | | | JP | 5221674 | B2 | 26 June 2013 |
| | | | | JP | 5478750 | B2 | 23 April 2014 |
| | | | | US | 2009-0151784 | A1 | 18 June 2009 |
| | | | | US | 2012-0255606 | A1 | 11 October 2012 |
| | | | | US | 2014-0373910 | A1 | 25 December 2014 |
| | | | | US | 8198528 | B2 | 12 June 2012 |
| | | | | US | 8748736 | B2 | 10 June 2014 |
| | | | | US | 9577120 | B2 | 21 February 2017 |
| | | | | WO | 2009-079199 | A1 | 25 June 2009 |
| KR | 10-2014-0037372 | A | 27 March 2014 | KR | 10-1410941 | B1 | 24 June 2014 |
| KR | 10-2020-0093856 | A | 06 August 2020 | KR | 10-2206298 | B1 | 21 January 2021 |

Form PCT/ISA/210 (patent family annex) (July 2019)